# FASCICULE DE BREVET EUROPEEN

(11) **EP 3 176 919 B1**
(45) Date de publication et mention de la délivrance du brevet: **19.12.2018**
(21) Numéro de dépôt: 16201084.7
(22) Date de dépôt: 29.11.2016
(51) Int. Cl.: H02K 5/14, H02K 5/22, H05K 5/00, H05K 7/14, H02K 11/04, H02K 11/33, H01R 12/70, H01R 13/405, H01R 43/24

(54) **CONNECTEUR ELECTRIQUE DESTINE A ETRE CONNECTE ELECTRIQUEMENT A UNE SOURCE D'ENERGIE ELECTRIQUE**
ELEKTRISCHER STECKVERBINDER ZUR ELEKTRISCHEN VERBINDUNG MIT EINER STROMQUELLE
ELECTRICAL CONNECTOR INTENDED FOR BEING ELECTRICALLY CONNECTED TO A SOURCE OF ELECTRICAL POWER

(30) Priorité: 02.12.2015 FR 1561735
(43) Date de publication de la demande: 07.06.2017
(73) Titulaire: Valeo Systemes de Controle Moteur, 95800 Cergy Saint Christophe (FR)
(72) Inventeur: TRAMET, Guillaume, 78360 Montesson (FR); MAS, Arnaud, 95000 Cergy (FR); SACCO, Ernesto, 95000 Cergy (FR)
(74) Mandataire: Novembre, Christophe Adelphe

(56) Documents cités:
- EP-A1- 2 913 909
- FR-A1- 3 020 726
- US-A1- 2008 124 970

## Description

L'invention a pour objet un connecteur électrique destiné à être connecté électriquement à une source d'énergie électrique.

L'invention concerne également un dispositif électrique destiné à alimenter une machine électrique pour véhicule automobile comprenant un tel connecteur électrique, et une machine électrique pour véhicule automobile comprenant un tel dispositif électrique.

Usuellement, une machine électronique, notamment pour véhicule automobile, comprend une unité électronique de contrôle, par exemple un module électronique de contrôle ou une carte électronique de contrôle. Cependant, une connexion électrique de ladite unité électronique de contrôle à une source d'énergie électrique peut être volumineuse, couteuse, et poser des difficultés de placement, notamment lorsque l'unité électronique de contrôle est destinée à être connectée électriquement à d'autres unités électroniques.
Le document US 2008/124970 A1 décrit un connecteur électrique conçu pour être connecté électriquement à une unité électronique au moyen d'ergots localisés sur les traces de puissance du connecteur.

Le document FR 3 020 726 A1 décrit un connecteur électrique destiné à être connecté électriquement à une source d'énergie électrique tel que revendiqué par le préambule de la revendication 1.

La présente invention vise à remédier à ces inconvénients en proposant un connecteur électrique permettant de réduire l'encombrement d'une connexion électrique d'une unité électronique à une source d'énergie électrique.

A cet effet, l'invention a pour objet un connecteur électrique tel que divulgué dans la revendication 1.

Avantageusement, un tel connecteur électrique permet un gain de place au sein de la machine électrique à laquelle il est destiné à être intégré. En outre, un tel connecteur électrique permet d'optimiser le fonctionnement de la machine électrique dans laquelle il est intégré.

Le connecteur électrique selon l'invention peut également comprendre une ou plusieurs des caractéristiques suivantes, considérées individuellement ou selon toutes les combinaisons possibles :
- l'ergot de chacune des au moins une première et deuxième traces de puissance est respectivement situé à une extrémité desdites au moins une première et deuxième traces de puissance ; et/ou
- l'ergot de la au moins une première trace de puissance est adjacent à l'ergot de la au moins une deuxième trace de puissance ; et/ou
- le surmoulage des au moins une première et deuxième traces de puissance relie mécaniquement l'ergot de la au moins une première trace de puissance et l'ergot de la au moins une deuxième trace de puissance ; et/ou

L'invention a également pour objet un dispositif électrique destiné à alimenter une machine électrique pour véhicule automobile, comprenant :
- une unité électronique, notamment une carte électronique, et
- un connecteur électrique selon l'invention,
dans lequel l'unité électronique est agencée en vis-à-vis du connecteur électrique, le connecteur électrique étant destiné à alimenter en énergie électrique l'unité électronique.

Avantageusement, un tel dispositif électrique permet une réduction des dimensions et des coûts de production de la machine électrique dans laquelle il est intégré.

Le dispositif électrique selon l'invention peut également comprendre une ou plusieurs des caractéristiques suivantes, considérées individuellement ou selon toutes les combinaisons possibles :
- le dispositif électrique comprend un joint s'étendant entre l'unité électronique et le connecteur électrique et autour de chaque ergot des au moins une première et deuxième traces de puissance ; et/ou
- le dispositif électrique comprend en outre une unité électronique de puissance, dans lequel ladite unité électronique est une unité électronique de contrôle des composants de l'unité électronique de puissance, et dans lequel les première et deuxième traces de puissance comprennent des bornes destinées à alimenter en énergie l'unité électronique de puissance depuis la source d'énergie électrique.

L'invention se rapporte également à une machine électrique pour véhicule automobile, comprenant au moins un dispositif électrique selon l'invention. Par exemple, la machine électrique est un démarreur, un alterno-démarreur ou une autre machine électrique embarquée dans le véhicule.

D'autres caractéristiques et avantages de la présente invention apparaitront à la lecture de la description et des figures suivantes :
- la figure 1a est une vue générale d'un connecteur électrique selon un mode de réalisation de l'invention,
- la figure 1b représente les traces de puissance sans surmoulage du connecteur électrique de la figure 1a,
- les figures 2a et 2b représentent des vues en coupe du connecteur électrique de la figure 1a selon un mode de réalisation de l'invention,
- la figure 3 est une vue selon un mode de réalisation d'un ensemble d'un connecteur électrique et d'un connecteur de bloc de capacités selon l'invention,
- la figure 4 représente les traces de puissance sans surmoulage du connecteur bloc de capacités de la figure 3,
- la figure 5 est une vue éclatée selon un mode de réalisation d'un dispositif électrique selon l'invention,
- la figure 6 est une vue en coupe selon un mode de réalisation d'un dispositif électrique assemblé de la figure 5 selon l'invention, et
- la figure 7 est une vue éclatée d'une machine électrique selon un mode de réalisation de l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

L'invention a pour objet un connecteur électrique destiné à être connecté électriquement à une source d'énergie électrique. Le connecteur électrique est destiné à être connecté à au moins une unité électronique, notamment destinée à être intégrée dans une machine électrique.

Dans la suite de la description, l'unité électronique sera illustrée par une unité électronique de contrôle, par exemple une carte électronique de contrôle.

Le connecteur électrique est de préférence destiné à être intégré dans une machine électrique, notamment une machine électrique pour véhicule automobile, telle qu'une machine électrique tournante.

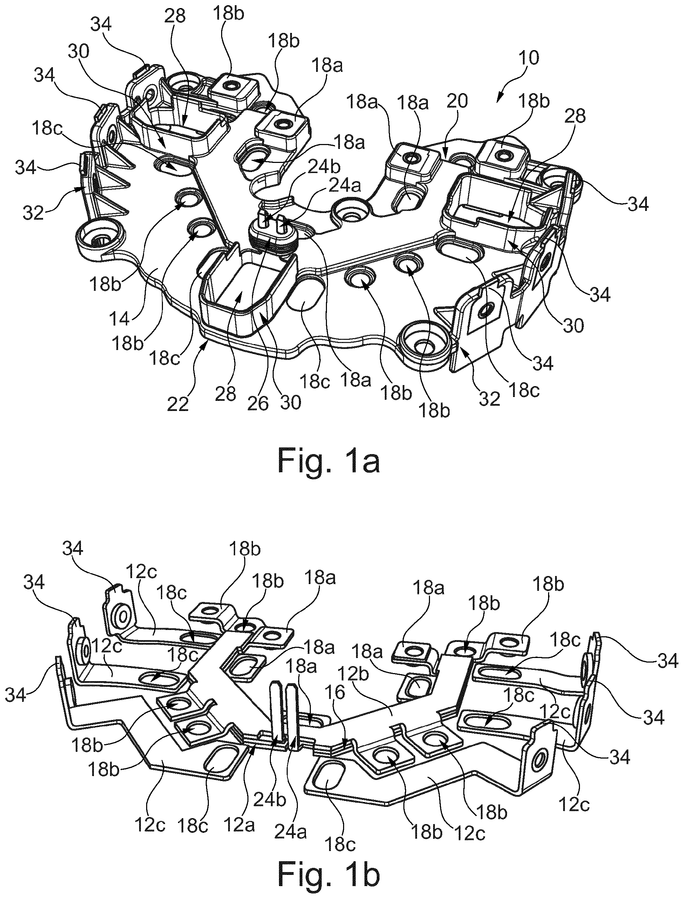

En particulier, la figure 1a représente un connecteur électrique 10 selon l'invention.

Comme illustré sur la figure 1a, le connecteur électrique 10 a une forme générale de fer à cheval permettant de loger un porte-balai de la machine électrique dans le creux du connecteur électrique 10. Le porte-balai comprend au moins deux balais réalisés en matériau électriquement conducteur et est destiné à permettre l'alimentation électrique d'un rotor de la machine électrique.

En particulier, le connecteur électrique 10 a une forme sensiblement plane comprenant une face supérieure 20 et une face inférieure 22.

En outre, le connecteur électrique 10 comprend au moins une première trace de puissance 12a et au moins une deuxième trace de puissance 12b, notamment visibles sur la figure 1b. De préférence, lesdites traces de puissance 12a, 12b sont comprises dans le plan du connecteur électrique 10. La première trace de puissance 12a est notamment destinée à être connectée électriquement à un pôle de polarité positive B⁺ de la source d'énergie électrique, et la deuxième trace de puissance est notamment destinée à être connectée électriquement à un pôle de polarité négative B⁻ ou à la masse de la source d'énergie électrique. En outre, la source d'énergie électrique peut être une source d'énergie électrique continue, le terme continue signifiant ici que l'énergie électrique est constante au cours du temps.

Les première et deuxième traces de puissance 12a, 12b sont également destinées à être connectées électriquement à une unité électronique, notamment à une carte électronique de contrôle, de sorte à alimenter en énergie électrique ladite unité électronique.

Les première et deuxième traces de puissance 12a, 12b sont distinctes l'une de l'autre et surmoulées au moins en partie de matériau isolant électriquement. Par exemple, une partie du surmoulage 14 des traces de puissance est visible sur la figure 1a, et les traces de puissance 12a, 12b représentées sans surmoulage sont visibles sur la figure 1b.

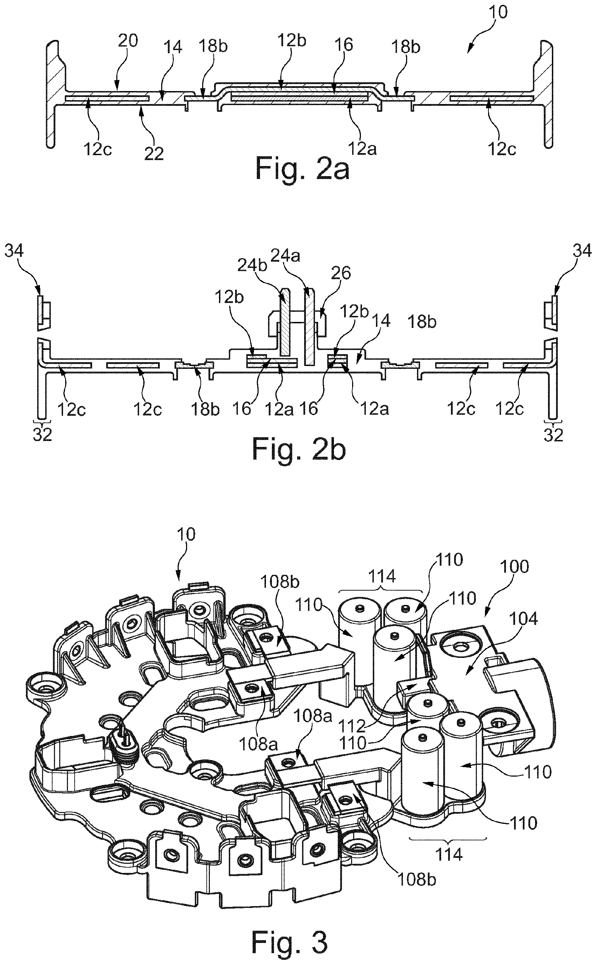

Comme représenté sur la figure 2a, les première et deuxième traces de puissance 12a, 12b sont au moins en partie superposées. Les traces de puissances 12a, 12b sont ainsi superposées selon une direction sensiblement perpendiculaire au plan du connecteur électrique 10. Autrement dit, les traces de puissance 12a, 12b sont au moins en partie disposées l'une au-dessus de l'autre dans la forme sensiblement plane du connecteur électrique.

Les première et deuxième traces de puissance 12a, 12b sont séparées par un matériau isolant 16, en général un matériau isolant électriquement comme par exemple un matériau plastique, notamment visible sur la figure 2a. De préférence, l'épaisseur du matériau isolant 16 séparant la superposition de deux portions de traces de puissance est supérieure ou égale à 50 microns et inférieure ou égale à 2 mm, notamment égale à 1 mm. Les première et deuxième traces de puissance 12a, 12b sont avantageusement superposées au plus proche possible l'une de l'autre, de sorte à réduire l'inductance parasite.

Comme représenté sur la figure 1b, les première et deuxième traces de puissance 12a, 12b telles que décrites précédemment comprennent chacune au moins un ergot 24a, 24b, également appelé broche, destiné à être connecté électriquement à une unité électronique, notamment à la carte électronique de contrôle. Les ergots 24a, 24b s'étendent de préférence depuis le plan du connecteur électrique 10 en direction de l'unité électronique de contrôle. Par exemple, sur la figure 1a, les ergots 24a, 24b s'étendent perpendiculairement depuis la face supérieure 20 du connecteur électrique 10. Notamment, l'ergot 24a, 24b est en métal.

Avantageusement, l'ergot 24a, 24b de chacune des première et deuxième traces de puissance 12a, 12b est respectivement situé au niveau d'un bord desdites au moins une première et deuxième traces de puissance 12a, 12b, comme illustré sur la figure 1b.

En outre, l'ergot 24a de la première trace de puissance 12a peut être adjacent à l'ergot 24b de la deuxième trace de puissance 12b, afin de faciliter la connexion avec l'unité électronique. Par exemple, sur la figure 1a, la forme sensiblement plane du connecteur électrique est sensiblement symétrique selon un plan perpendiculaire au plan du connecteur électrique, et les ergots 24a, 24b sont adjacents et situés sur, ou de part et d'autre, du plan de symétrie du connecteur électrique 10. De préférence, comme représenté sur la figure 2b, le surmoulage 14 des première et deuxième traces de puissance 12a, 12b relie mécaniquement l'ergot 24a de la première trace de puissance 12a et l'ergot 24b de la deuxième trace de puissance 12b.

Selon un mode de réalisation de l'invention compatible avec le mode de réalisation précédemment décrit, le connecteur électrique 10 peut également être destiné à être connecté électriquement à au moins une autre unité électronique, illustrée par la suite par une unité électronique de puissance, par exemple une unité électronique de puissance comprenant une pluralité de modules électroniques de puissance, ici au nombre de trois. Un module électronique de puissance est notamment destiné à alimenter en puissance la machine électrique depuis une source d'énergie électrique.

Avantageusement, le connecteur électrique 10 est agencé entre les deux unités électroniques, ici une carte électronique de contrôle et des modules électroniques de puissance de sorte que le connecteur électrique et lesdites unités électroniques sont superposés selon un axe sensiblement perpendiculaire au plan du connecteur électrique. En particulier, les unités électroniques peuvent être de forme sensiblement plane et s'étendre sensiblement selon des plans parallèles au plan du connecteur électrique. Par exemple, la face supérieure du connecteur électrique peut être agencée en vis-à-vis de la carte électronique de contrôle, et la face inférieure du connecteur électrique peut être agencée en vis-à-vis des modules électroniques de puissance.

Avantageusement, les première et deuxième traces de puissance 12a, 12b comprennent chacune au moins une borne destinée à être connectée électriquement à une unité électronique, par exemple à un module électronique de puissance et/ou à un connecteur de bloc de capacités, tel que détaillé par la suite. En particulier, chaque borne est destinée à alimenter en énergie une unité électronique depuis la source d'énergie électrique.

Chaque borne est de préférence située dans le plan du connecteur électrique, et est rendue accessible par une fenêtre dans le matériau isolant électriquement. Autrement dit, une borne est au moins en partie dépourvue de surmoulage 14 de sorte qu'un contact électrique puisse être réalisé entre ladite borne et une unité électronique.

En particulier, chaque borne forme une excroissance 18a, 18b, notamment visible sur la figure 1b, extérieure à la superposition desdites traces de puissance 12a, 12b. Par exemple, sur la figure 1b, la trace de puissance 12a comprend cinq excroissances 18a et la trace de puissance 12b comprend huit excroissances 18b. En particulier, trois excroissances 18a sont destinées à être connectées électriquement à une unité électronique et deux excroissances 18a sont destinées à être connectées électriquement au connecteur de bloc de capacités. De même, six excroissances 18b sont destinées à être connectées électriquement à une unité électronique et deux excroissances 18b sont destinées à être connectées électriquement au connecteur de bloc de capacités. En outre, deux excroissances 18b de la trace de puissance 12b sont visibles sur les figures 2a et 2b, les excroissances 18b étant dépourvues de surmoulage au niveau de la face supérieure 20 et de la face inférieure 22 du connecteur électrique 10.

De façon avantageuse, les première et deuxième traces de puissance 12a, 12b sont totalement superposées sauf au niveau des excroissances de chaque trace de puissance 12a, 12b de sorte à permettre une connexion électrique entre le connecteur électrique et une unité électronique, tout en maximisant la surface de superposition des traces de puissance.

En outre, le connecteur électrique comprend également au moins une trace de puissance 12c, notamment visible sur la figure 2, destinée à être connectée électriquement à au moins un des éléments électriques, par exemple une phase, de la machine électrique et à une unité électronique. Par exemple, le connecteur électrique 10 de la figure 1a est destiné à être connecté à trois unités électroniques, et comprend trois paires de traces de puissance 12c, notamment visibles sur la figure 1b. Chaque paire de traces de puissance 12c permet une liaison électrique entre une unité électronique et une phase de la machine électrique.

Avantageusement, chaque trace de puissance 12c comprend au moins une borne, telle que décrite précédemment, destinée à être connectée électriquement à une unité électronique. Par exemple, comme illustré sur la figure 1b, le connecteur électrique 10 comprend six de traces de puissance 12c, chaque trace de puissance 12c comprenant une borne 18c.

En outre, le connecteur électrique 10 comprend avantageusement au moins un muret 32 s'étendant depuis la forme sensiblement plane du connecteur électrique 10 dans une direction sensiblement perpendiculaire au plan du connecteur électrique 10. Plus précisément, un muret 32 tel que représenté sur la figure 1a, est formé par au moins une portion d'une trace de puissance 12c surmoulée au moins en partie de matériau isolant électriquement. Autrement dit, comme visible sur la figure 1b, chaque trace de puissance 12c forme un coude entre le plan du connecteur électrique et un plan sensiblement perpendiculaire audit plan du connecteur électrique.

En particulier, les traces de puissance 12c, notamment les portions des traces de puissance 12c formant les murets 32, sont destinées à être vissées à la machine électrique dans laquelle le connecteur est destiné à être intégré.

Chaque trace de puissance 12c comprend une excroissance 34 dépourvue de surmoulage 14, notamment dans une direction sensiblement perpendiculaire au plan du connecteur électrique. Ces excroissances 34 permettent notamment un contact électrique avec chaque trace de puissance 12c dans une direction sensiblement perpendiculaire au plan du connecteur électrique.

De préférence, comme représenté sur la figure 1b, chaque excroissance 34 est située à une extrémité d'une trace de puissance 12c.

De façon avantageuse, les murets 32 sont situés sur le pourtour de la forme sensiblement plane du connecteur électrique, et les murets 32 s'étendent depuis la face supérieure 20 du connecteur électrique, tel que représenté sur la figure 1a.

En outre, les unités électroniques sont destinées à être connectées électriquement via au moins un élément de connexion électrique. En particulier la forme sensiblement plane du connecteur électrique 10 comprend au moins un orifice traversant 28 destiné à recevoir le au moins un élément de connexion électrique.

De préférence, l'orifice traversant 28 comprend au moins une paroi latérale 30 s'étendant depuis la partie sensiblement plane du connecteur électrique 10.

Selon un mode de réalisation de l'invention, l'orifice traversant 28 a une forme générale de cylindre, la paroi latérale 30 s'étendant dans une direction sensiblement perpendiculaire au plan du connecteur électrique 10, notamment en direction de la carte électronique. Par exemple, sur la figure 1a, la paroi latérale 30 s'étend perpendiculairement depuis la face supérieure 22 du connecteur électrique.

Selon une variante, l'orifice traversant 28 peut avoir une forme générale de cône, la paroi latérale 30 s'étendant dans une direction inclinée par rapport au plan du connecteur électrique 10.

De façon avantageuse, la paroi latérale 30 permet de protéger mécaniquement les éléments de connexion électrique.

Avantageusement, la paroi latérale 30 comprend au moins une partie du pourtour de l'orifice traversant 28, comme illustré sur la figure 1a. La paroi latérale a de préférence une hauteur supérieure ou égale à 1 mm et inférieure ou égale à 10 mm, notamment égale 6 mm et une épaisseur inférieure ou égale à 3 mm et supérieure ou égale à 0,5 mm.

Le connecteur électrique 10 peut comprendre une pluralité d'orifices traversants 28, au nombre de trois sur la figure 1a, chaque orifice traversant 28 étant destiné à recevoir au moins un élément de connexion électrique.

L'invention a également pour objet dispositif électrique destiné à alimenter une machine électrique.

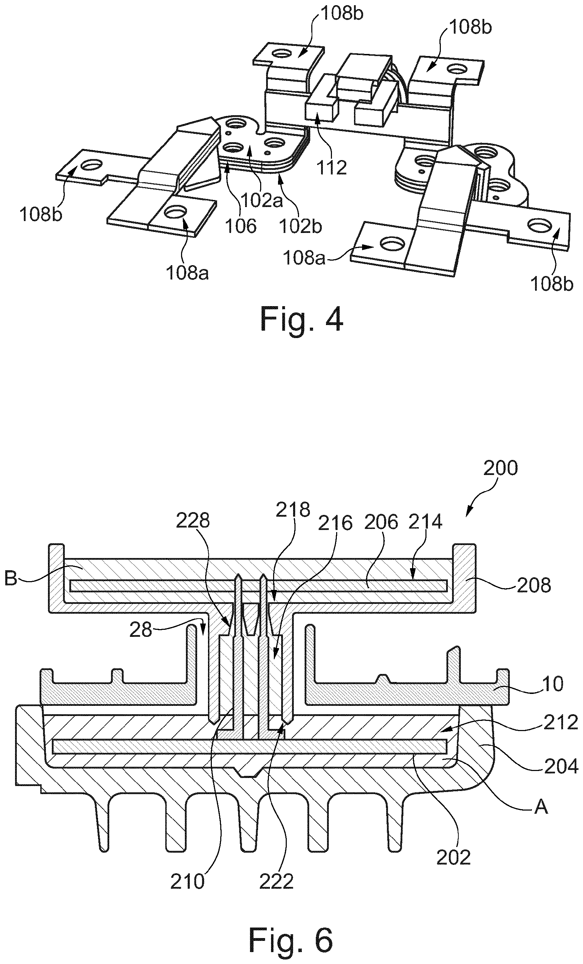

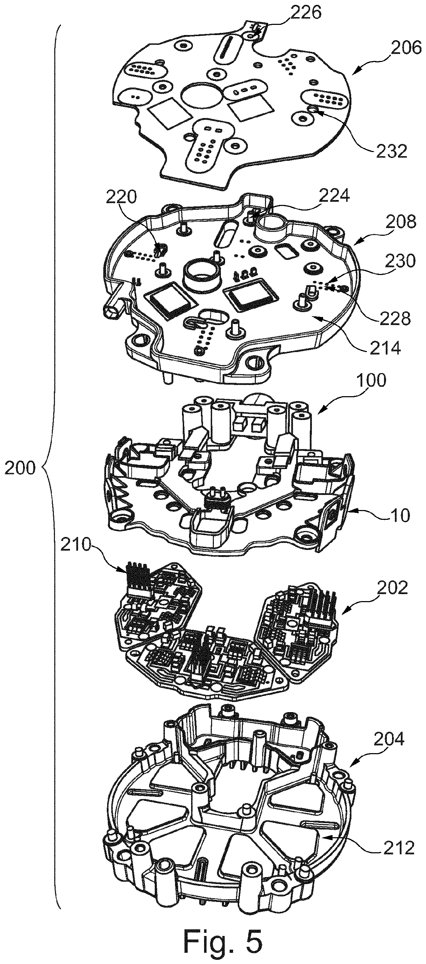

En particulier, les figures 5 et 6 représentent respectivement une vue éclatée et une vue en coupe d'un mode de réalisation d'un tel dispositif électrique 200. Le dispositif électrique 200 comprend au moins une unité électronique, notamment une carte électronique de contrôle et un connecteur électrique 10 tel que décrit précédemment. L'unité électronique est agencée en vis-à-vis du connecteur électrique, le connecteur électrique étant destiné à alimenter en énergie électrique l'unité électronique.

Le dispositif électrique peut également comprendre un joint 26, notamment visible sur les figures 1a et 2b, s'étendant entre l'unité électronique, ici la carte électronique, et le connecteur électrique 10 et autour de chaque ergot 24a, 24b, des au moins une première et deuxième traces de puissance du connecteur électrique, permettant de garantir l'étanchéité entre le connecteur électrique 10 et l'unité électronique au niveau des ergots. En particulier, l'unité électronique étant destinée à être isolée avec un matériau isolant, ce joint 26 permet en outre d'éviter que le matériau isolant s'écoule autour des ergots 24a, 24b.

Avantageusement, le dispositif électrique comprend également une autre unité électronique, ici trois modules électroniques de puissance. En outre, le dispositif électrique peut également comprendre un support 204 des modules électroniques, un support 208 de carte électronique, un élément de connexion électrique, et un connecteur de bloc de capacités.

Le connecteur électrique 10 et le connecteur de bloc de capacités 100 sont de préférence agencés entre les unités électroniques, de sorte que l'ensemble et lesdites unités électroniques sont superposés. Le connecteur électrique 10 et le connecteur de bloc de capacités 100 sont destinés à être connectés électriquement de sorte à fournir de la puissance à au moins une unité électronique.

Le connecteur de bloc de capacités 100 peut avoir une forme générale de fer à cheval. En particulier, comme illustré sur la figure 3, l'ensemble du connecteur de bloc de capacités 100 et du connecteur électrique 10 forme le pourtour d'un orifice destiné à recevoir le porte-balai de la machine électrique.

Le connecteur de bloc de capacités 100 comprend au moins une troisième trace de puissance 102a et au moins une quatrième trace de puissance 102b, notamment visibles sur la figure 4. La troisième trace de puissance 102a est notamment destinée à être connectée électriquement à un pôle de polarité positive B⁺ de la source d'énergie électrique, et la quatrième trace de puissance 102b est notamment destinée à être connectée électriquement à un pôle de polarité négative B⁻ ou à la masse de la source d'énergie électrique, la source d'énergie électrique étant notamment une source d'énergie électrique continue. Les troisième et quatrième traces de puissance 102a, 102b sont distinctes l'une de l'autre et surmoulées au moins en partie de matériau isolant électriquement, par exemple de matériau plastique. Par exemple, les traces de puissance 102a, 102b représentées sans surmoulage sont visibles sur la figure 4, et une partie du surmoulage 104 des traces de puissance 102a, 102b est visible sur la figure 3.

De façon analogue aux première et deuxième traces de puissance 12a, 12b, les troisième et quatrième traces de puissance 102a, 102b sont, de préférence, au moins en partie superposées et séparées par un matériau isolant 106, notamment visible sur la figure 4. Plus précisément, les traces de puissances 102a, 120b sont au moins en partie disposées l'une au-dessus de l'autre au sein du connecteur de bloc de capacités 100. Par exemple, comme représenté sur la figure 4, au moins une portion des troisième et quatrième traces de puissance 102a, 102b sont superposées selon une direction sensiblement perpendiculaire au plan du connecteur électrique 10. En particulier, une portion de la troisième trace de puissance 102a est destinée à être en vis-à-vis de la quatrième trace de puissance 102b et de la carte unité électronique, et une portion de la quatrième trace de puissance 102b est destinée à être en vis-à-vis de la troisième trace de puissance et d'un module électronique de puissance. Les troisième et quatrième traces de puissance 102a, 102b sont avantageusement superposées au plus proche possible l'une de l'autre, de sorte à réduire l'inductance parasite générée par la superposition des troisième et quatrième traces de puissance 102a, 102b.

De préférence, les troisième et quatrième traces de puissance 102a, 102b peuvent comprendre chacune au moins une borne destinée à être connectée électriquement à l'unité électronique et au connecteur électrique 10 de sorte à fournir de la puissance à ladite unité électronique. Une borne est de préférence dépourvue de surmoulage 104 de sorte qu'un contact électrique puisse être réalisé entre ladite borne et l'unité électronique. En particulier, une borne forme une excroissance extérieure à la superposition desdites traces de puissance 102a, 102b. Comme illustré sur la figure 4, la trace de puissance 102b comprend quatre bornes 108b et la trace de puissance 102a comprend deux bornes 108a.

Avantageusement, comme représenté sur la figure 3, une borne 108a de la troisième trace de puissance du connecteur de blocs de capacités 100 et une borne de la première trace de puissance du connecteur électrique 10 sont connectées électriquement, et une borne 108b de la quatrième trace de puissance du connecteur de blocs de capacités 100 et une borne de la deuxième trace de puissance du connecteur électrique 10 sont connectées électriquement.

En outre, le connecteur de bloc de capacités 100 peut comprendre au moins une capacité de liaison 110. Par exemple, comme illustré sur la figure 3, le connecteur de bloc de capacités 100 comprend deux blocs de capacités 114, chaque bloc de capacité 114 comprenant trois capacités de liaison 110.

De façon additionnelle, le connecteur de blocs de capacités 100 peut comprendre un tore magnétique 112, visible sur les figures 3 et 4, destiné à mesurer un courant électrique.

La carte électronique de contrôle 206 est notamment configurée pour contrôler les composants des modules électroniques de puissance 202. En particulier, la carte électronique 206 est destinée à être connectée électriquement avec chaque module électronique de puissance 202 via au moins un élément de connexion électrique 210.

Un module électronique de puissance 202 comprend de préférence un substrat plan comprenant trois traces de puissance surmoulées au moins en partie de matériau isolant électriquement, de préférence de matériau plastique. Chaque trace de puissance du module électronique 202 comprend au moins une portion dépourvue de surmoulage, notamment destinée à être connectée électriquement au connecteur électrique 10. Plus précisément, la connexion électrique du module électronique de puissance 202 avec le connecteur électrique 10 est effectuée via un élément de connexion extérieur. L'élément de connexion extérieure peut comprendre une languette en matériau conducteur pliée, notamment en forme de « Z », de sorte à comprendre au moins une face plane inférieure en contact avec une partie de la trace de puissance du module électronique 202 qui est à nue et une face plane supérieure en contact avec une borne d'une trace de puissance du connecteur électrique 10.

Le support 204 des modules électroniques de puissance est avantageusement un boitier comprenant au moins une cavité ouverte 212 ayant un fond sur lequel les modules électroniques de puissance 202 sont montés. En particulier, comme illustré sur la figure 5, la cavité ouverte 212 peut recevoir trois modules électroniques de puissance 202.

En outre, la cavité ouverte 212 est destinée à être remplie d'un matériau isolant A, notamment visible sur la figure 6, de sorte que les modules électroniques de puissance 202 sont noyés dans le matériau isolant A. En particulier, cette configuration permet une isolation efficace des modules électroniques 202. Par exemple, le matériau isolant A peut être une résine, telle qu'une résine époxy, ou un gel isolant, tel qu'un gel de silicone. De façon avantageuse, le support 204 de module de puissance est un dissipateur de chaleur, aussi nommé dissipateur thermique.

Le support 208 de la carte électronique de contrôle est agencé entre les modules électroniques de puissance 202 et la carte électronique de contrôle 206. Le support 208 de la carte électronique de contrôle est de préférence en matière isolante, par exemple moulé en matière plastique. Le support 208 comprend une cavité ouverte 214 ayant un fond sur lequel la carte électronique 206 est destinée à être reçue.

Le support 208 comprend également au moins une colonne creuse 216, notamment visible sur la figure 6, dans laquelle les éléments de connexion électrique 210 de la carte électronique 206 avec les modules électroniques 202 sont insérés. En particulier, la colonne creuse 216 est insérée dans l'orifice traversant 28 du connecteur électrique 10 de sorte que les éléments de connexion électrique 210 connectent électriquement la carte électronique 206 et les modules électroniques 202.

La colonne creuse 216 s'étend depuis la cavité ouverte 214 et est configurée pour communiquer avec la cavité ouverte 214 à une première extrémité 218 de la colonne creuse 216. En particulier, sur la figure 5, le support 208 de la carte électronique 206 comprend trois colonnes creuses, chaque colonne creuse étant destinée à recevoir les éléments de connexion électrique 210 de chaque module électronique 202 avec la carte électronique de contrôle 206. La cavité ouverte 214 est destinée à être remplie d'un matériau isolant B de sorte que la carte électronique de contrôle 206 est noyée dans le matériau isolant B. La carte électronique de contrôle 206 est ainsi isolée de manière efficace.

En particulier, la carte électronique de contrôle 206 et les modules électroniques de puissance 202 peuvent être isolés avec des matériaux isolants A, B identiques ou différents, de préférence un matériau isolant identique, notamment un gel isolant.

De préférence, comme illustré sur la figure 6, une seconde extrémité 222 de la colonne creuse 216 est en contact avec le matériau isolant A dans lequel le module électronique 202 est noyé. Cette configuration permet de garantir le remplissage de la colonne creuse 216 de matériau isolant, et ainsi d'assurer une isolation efficace des éléments de connexion électrique 210.

L'interface entre le matériau isolant A du module électronique de puissance 202 et le matériau isolant B de la carte électronique de contrôle 206 est notamment située à l'intérieur de la colonne creuse 216, à proximité de la seconde extrémité 222 de la colonne creuse 216.

En outre, l'espace compris entre la carte électronique 206 et le module de puissance 202 et entourant la colonne creuse 216 est dépourvu de matière, notamment de matériau isolant. En particulier, le connecteur électrique 10 est agencé dans cet espace libre de matière, comme représenté sur la figure 6. L'espace libre de matière a, entre autres, pour effet de laisser un espace libre pour la circulation d'air, permettant ainsi un refroidissement par convection. De plus, cette configuration permet de diminuer les coûts de production du dispositif électrique 200, grâce notamment à un gain en matériau isolant.

De plus, le fond de la cavité ouverte 214 comprend avantageusement des éléments de guidage 228 du au moins un élément de connexion électrique 210, notamment visibles sur la figure 6, agencés à la première extrémité 218 de la colonne creuse 216 et destinés à guider le au moins un élément de connexion électrique 210 vers la carte électronique 206.

En particulier, une trace de puissance est une trace conductrice électriquement, notamment métallique, par exemple en forme de lame, telle qu'entre autres une lame de cuivre.

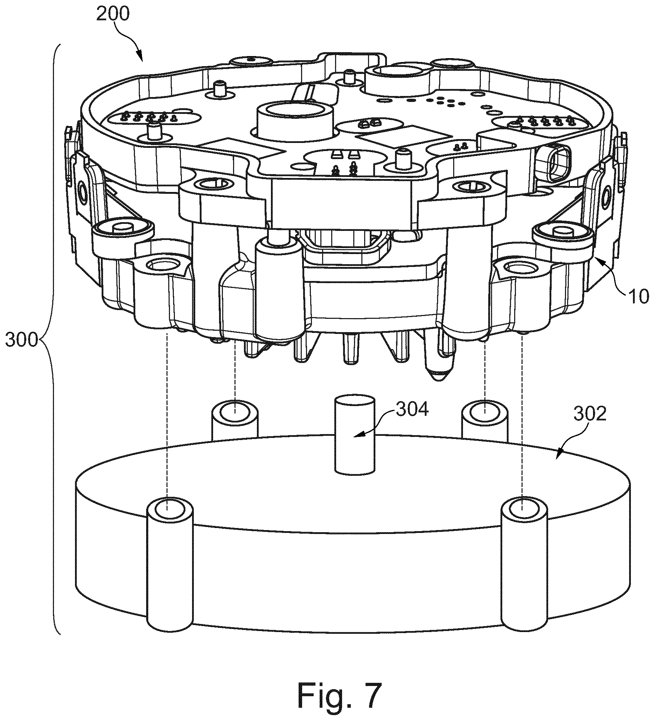

En outre, l'invention concerne également une machine électrique pour véhicule automobile comprenant une architecture électronique 200 selon l'invention. En particulier, une telle machine électrique est représentée en figure 7.

La machine électrique 300 comprend un carter 302 et un rotor 304. Le rotor 304 de la machine électrique 300 est destiné à être connecté électriquement aux balais du porte-balais de la machine électrique logé dans le creux de la forme de fer à cheval du connecteur électrique 10. L'architecture électronique 200 est notamment destinée à être vissée au carter de la machine électrique 300.

Le dispositif électrique destiné à alimenter une machine électrique a été décrit dans le cadre d'une pluralité de modules électroniques de puissance et d'une carte électronique de contrôle desdits modules électroniques de puissance. Bien entendu, l'invention n'est nullement limitée au mode de réalisation décrit et illustré, qui n'a été donné qu'à titre d'exemple. Au contraire, d'autres applications du connecteur électrique conforme à l'invention sont également possibles sans sortir du cadre de l'invention tel que défini par les revendications jointes.

## Revendications

1. Connecteur électrique (10) destiné à être connecté électriquement à une source d'énergie électrique, le connecteur électrique (10) ayant une forme générale de fer à cheval, ladite forme étant sensiblement plane et comprenant une face supérieure (20) et une face inférieure (22), ledit connecteur électrique (10) comprenant :
- au moins une première trace de puissance (12a) destinée à être connectée électriquement à un pôle de polarité positive (B⁺) de la source d'énergie électrique, et
- au moins une deuxième trace de puissance (12b) destinée à être connectée électriquement à un pôle de polarité négative (B⁻) de la source d'énergie électrique
dans lequel les au moins une première et deuxième traces de puissance (12a, 12b) sont surmoulées au moins en partie de matériau isolant électriquement, et
**caractérisé en ce que** les traces de puissance (12a, 12b) sont au moins en partie superposées selon une direction sensiblement perpendiculaire au plan du connecteur électrique (10), lesdites traces (12a, 12b) étant séparées par un matériau isolant (18), et **en ce que** les au moins une première et deuxième traces de puissance (12a, 12b) comprennent chacune un ergot (24a, 24b) destiné à être connecté électriquement à une unité électronique (206), notamment une carte électronique, notamment destinée à être intégrée dans une machine électrique, de sorte à alimenter en énergie électrique l'unité électronique (206).

2. Connecteur électrique selon la revendication 1, dans lequel l'ergot (24a, 24b) de chacune des au moins une première et deuxième traces de puissance (12a, 12b) est respectivement situé à une extrémité desdites au moins une première et deuxième traces de puissance (12a, 12b).

3. Connecteur électrique selon les revendications précédentes, dans lequel l'ergot (24a) de la au moins une première trace de puissance (12a) est adjacent à l'ergot (24b) de la au moins une deuxième trace de puissance (12b).

4. Connecteur électrique selon l'une quelconque des revendications 1 à 3, dans lequel le surmoulage (14) des au moins une première et deuxième traces de puissance (12a, 12b) relie mécaniquement l'ergot (24a) de la au moins une première trace de puissance (12a) et l'ergot (24b) de la au moins une deuxième trace de puissance (12b).

5. Dispositif électrique (200) destiné à alimenter une machine électrique pour véhicule automobile, comprenant :
- une unité électronique (206), notamment une carte électronique, et
- un connecteur électrique (10) selon l'une quelconque des revendications 1 à 4,
dans lequel l'unité électronique (206) est agencée en vis-à-vis du connecteur électrique (10), le connecteur électrique (10) étant destiné à alimenter en énergie électrique l'unité électronique (206).

6. Dispositif électrique selon la revendication 5, comprenant un joint (26) s'étendant entre l'unité électronique (206) et le connecteur électrique (10) et autour de chaque ergot (24a, 24b) des au moins une première et deuxième traces de puissance (12a, 12b).

7. Dispositif électrique selon la revendication 5 ou 6, comprenant en outre une unité électronique de puissance (202), et dans lequel ladite unité électronique (206) est une unité électronique de contrôle des composants de l'unité électronique de puissance (202), et dans lequel les première et deuxième traces de puissance (12a, 12b) comprennent des bornes (108a, 108b) destinées à alimenter en énergie l'unité électronique de puissance (202) depuis la source d'énergie électrique.

8. Machine électrique pour véhicule automobile, comprenant au moins un dispositif électrique (200) selon l'une des revendications 5 à 7.

## Patentansprüche

1. Elektrischer Steckverbinder (10), der dazu bestimmt ist, elektrisch mit einer Stromquelle verbunden zu sein, wobei der elektrische Steckverbinder (10) eine allgemeine Hufeisenform hat, wobei die Form im Wesentlichen flach ist und eine obere Fläche (20) und eine untere Fläche (22) umfasst, wobei der elektrische Steckverbinder (10) Folgendes umfasst:
- mindestens eine erste Leistungsbahn (12a), die dazu bestimmt ist, elektrisch mit einem Pol mit positiver Polung (B⁺) der Stromquelle verbunden zu sein, und
- mindestens eine zweite Leistungsbahn (12b), die dazu bestimmt ist, elektrisch mit einem Pol mit negativer Polung (B⁻) der Stromquelle verbunden zu sein,
wobei die mindestens eine und mindestens eine zweite Leistungsbahn (12a, 12b) mindestens zum Teil mit elektrisch isolierendem Material umspritzt sind, und **dadurch gekennzeichnet, dass**
die Leistungsbahnen (12a, 12b) mindestens zum Teil gemäß einer Richtung, die im Wesentlichen zu der Ebene des elektrischen Steckverbinders (10) senkrecht ist, überlagert sind, wobei die Bahnen (12a, 12b) durch ein isolierendes Material (18) getrennt sind, und dass die mindestens eine erste und mindestens eine zweite Leistungsbahn (12a, 12b) jeweils einen Dorn (24a, 24b) umfassen, der dazu bestimmt ist, elektrisch an eine elektronische Einheit (206), insbesondere eine Elektronikkarte, angeschlossen zu sein, die insbesondere dazu bestimmt ist, in eine elektrische Maschine integriert zu sein, um die elektronische Einheit (206) mit Strom zu versorgen.

2. Elektrischer Steckverbinder nach Anspruch 1, wobei der Dorn (24a, 24b) jeder der mindestens einen ersten und mindestens einen zweiten Leistungsbahn (12a, 12b) jeweils an einem Ende der mindestens einen ersten und mindestens einen zweiten Leistungsbahn (12a, 12b) liegt.

3. Elektrischer Steckverbinder nach einem der vorhergehenden Ansprüche, wobei der Dorn (24a) der mindestens einen ersten Leistungsbahn (12a) zu dem Dorn (24b) der mindestens einen zweiten Leistungsbahn (12b) benachbart ist.

4. Elektrischer Steckverbinder nach einem der Ansprüche 1 bis 3, wobei das Umspritzen (14) der mindestens einen ersten und mindestens einen zweiten Leistungsbahn (12a, 12b) den Dorn (24a) der mindestens einen ersten Leistungsbahn (12a) und den Dorn (24b) der mindestens einen zweiten Leistungsbahn (12b) mechanisch verbindet.

5. Elektrische Vorrichtung (200), die dazu bestimmt ist, eine elektrische Maschine für Kraftfahrzeug zu versorgen, die Folgendes umfasst:
- eine elektronische Einheit (206), insbesondere eine Elektronikkarte, und
- einen elektrischen Steckverbinder (10) nach einem der Ansprüche 1 bis 4, wobei die elektronische Einheit (206) in Gegenüberlage zu dem elektrischen Steckverbinder (10) eingerichtet ist, wobei der elektrische Steckverbinder (10) dazu bestimmt ist, die elektronische Einheit (206) mit Strom zu versorgen.

6. Elektrische Vorrichtung nach Anspruch 5, die eine Dichtung (26) umfasst, die sich zwischen der elektronischen Einheit (206) und dem elektrischen Steckverbinder (10) sowie um jeden Dorn (24a, 24b) der mindestens einen ersten und mindestens einen zweiten Leistungsbahn (12a, 12b) erstreckt.

7. Elektrische Vorrichtung nach Anspruch 5 oder 6, die außerdem eine elektronische Leistungseinheit (202) umfasst, und wobei die elektronische Einheit (206) eine elektronische Einheit zum Steuern der Bauelemente der elektronischen Leistungseinheit (202) ist, und wobei die erste und zweite Leistungsbahn (12a, 12b) Klemmen (108a, 108b) umfassen, die dazu bestimmt sind, die elektronische Leistungseinheit (202) ausgehend von der Stromquelle mit Strom zu versorgen.

8. Elektrische Maschine für Kraftfahrzeug, die mindestens eine elektrische Vorrichtung (200) nach einem der Ansprüche 5 bis 7 umfasst.

## Claims

1. Electrical connector (10) intended to be electrically connected to an electric power source, the electrical connector (10) having the general shape of a horseshoe, said shape being substantially flat and comprising an upper face (20) and a lower face (22), said electrical connector (10) comprising:
- at least one first power trace (12a) intended to be electrically connected to a pole with positive polarity (B⁺) of the electric power source, and
- at least one second power trace (12b) intended to be electrically connected to a pole with negative polarity (B⁻) of the electric power source,
wherein the at least one first and second power trace (12a, 12b) are at least partly overmoulded with electrically insulating material, and
**characterized in that**
the power traces (12a, 12b) are at least partly superimposed in a direction substantially perpendicular to the plane of the electrical connector (10), said traces (12a, 12b) being separated by an insulating material (18),
and **in that**
the at least one first and second power trace (12a, 12b) each comprise a lug (24a, 24b) intended to be electrically connected to an electronic unit (206), in particular an electronic board, in particular intended to be integrated into an electrical machine, so as to supply electric power to the electronic unit (206).

2. Electrical connector according to Claim 1, wherein the lug (24a, 24b) of each of the at least one first and second power trace (12a, 12b) is situated respectively at one end of said at least one first and second power trace (12a, 12b).

3. Electrical connector according to the preceding claims, wherein the lug (24a) of the at least one first power trace (12a) is adjacent to the lug (24b) of the at least one second power trace (12b).

4. Electrical connector according to any one of Claims 1 to 3, wherein the overmoulding (14) of the at least one first and second power trace (12a, 12b) mechanically connects the lug (24a) of the at least one first power trace (12a) and the lug (24b) of the at least one second power trace (12b).

5. Electrical device (200) intended to supply power to an electrical machine for a motor vehicle, comprising:
- an electronic unit (206), in particular an electronic board, and
- an electrical connector (10) according to any one of Claims 1 to 4, wherein the electronic unit (206) is arranged facing the electrical connector (10), the electrical connector (10) being intended to supply electric power to the electronic unit (206).

6. Electronic device according to Claim 5, comprising a seal (26) extending between the electronic unit (206) and the electrical connector (10) and around each lug (24a, 24b) of the at least one first and second power trace (12a, 12b).

7. Electronic device according to Claim 5 or 6, furthermore comprising a power electronics unit (202), and wherein said electronic unit (206) is an electronic unit for controlling the components of the power electronics unit (202), and wherein the first and second power traces (12a, 12b) comprise terminals (108a, 108b) intended to supply electric power to the power electronics unit (202) from the electric power source.

8. Electrical machine for a motor vehicle, comprising at least one electrical device (200) according to one of Claims 5 to 7.
